# FASCICULE DE BREVET EUROPEEN

(11) **EP 0 843 350 B1**
(45) Date de publication et mention de la délivrance du brevet: **21.07.2004**
(21) Numéro de dépôt: 97410130.5
(22) Date de dépôt: 18.11.1997
(51) Int. Cl.: H01L 21/331, H01L 21/8249

(54) **Transistor bipolaire à émetteur inhomogène dans un circuit intégré BICMOS**
Bipolartransistor mit einem nicht homogenen Emitter in einer BICMOS integrierter Schaltung
Bipolar transistor having a non homogeneous emitter in a BICMOS integrated circuit

(30) Priorité: 19.11.1996 FR 9614409
(43) Date de publication de la demande: 20.05.1998
(73) Titulaire: STMicroelectronics S.A., 92120 Montrouge (FR)
(72) Inventeur: Gris, Yvon, 3210 Tullins (FR)
(74) Mandataire: de Beaumont, Michel

(56) Documents cités:
- EP-A- 0 606 001
- HAYDEN J D ET AL: "AN ULTRA-SHALLOW LINK BASE FOR A DOUBLE POLYSILICON BIPOLAR TRANSISTOR" PROCEEDINGS OF THE BIPOLAR/BICMOS CIRCUITS AND TECHNOLOGY MEETING, MINNEAPOLIS, OCT. 7 - 8, 1992, 5 octobre 1992, INSTITUTE OF ELECTRICAL AND ELECTRONICS ENGINEERS, pages 96-99, XP000340155

## Description

La présente invention concerne une filière de fabrication de circuits intégrés susceptibles de contenir notamment des composants bipolaires et MOS complémentaires (CMOS). Ce type de filière est habituellement appelé filière BICMOS.

Un procédé de fabrication d'un transistor de type NPN similaire à celui de la présente demande est décrit dans "Proceedings of the Bipolar/BICMOS Circuits and Technology Meeting, Minneapolis, Oct. 7-8, 1992, 5 octobre 1982, Institute of Electrical and Electronic Engineers, pages 69-99.

Un objet de la présente invention est de prévoir une telle filière dans laquelle les dimensions d'un élément dessiné sur un masque peuvent être d'une dimension inférieure ou égale à 0,4 µm, par exemple 0,2 à 0,35 µm.

Un objet plus particulier de la présente invention est de prévoir une telle filière dans laquelle les propriétés des transistors bipolaires de type NPN sont optimisées.

Pour atteindre ces objets, la présente invention prévoit un procédé de fabrication d'un transistor bipolaire de type NPN, comportant les étapes suivantes consécutives consistant à former une couche épitaxiée de type N sur un substrat de type P, une couche enterrée étant prévue au moins à l'emplacement du transistor bipolaire ; former une couche d'oxyde épais ouverte à l'emplacement de base-émetteur du transistor bipolaire ; former une première couche de silicium polycristallin ou amorphe dopée de type P et une deuxième couche d'oxyde d'encapsulation ; ouvrir ces deux dernières couches au centre de la région d'émetteur-base du transistor bipolaire ; faire diffuser le dopant contenu dans la première couche de silicium dans la couche épitaxiée sous-jacente, pour former la base extrinsèque du transistor bipolaire, étape pendant laquelle il se forme une couche mince d'oxyde sur les surfaces apparentes de silicium ; déposer une première couche de nitrure de silicium, déposer une deuxième couche de silicium polycristallin, et graver de façon anisotrope la deuxième couche de silicium polycristallin pour laisser en place des espaceurs dans les portions verticales de celle-ci ; éliminer le nitrure de silicium apparent et le surgraver sous les espaceurs ; éliminer la couche mince d'oxyde aux emplacements où le nitrure de silicium apparent a été surgravé ; implanter un dopant de collecteur de type N ; implanter un dopant de type P pour former la base intrinsèque du transistor bipolaire ; déposer une troisième couche de silicium polycristallin fortement dopée de type N de façon qu'elle pénètre dans la zone surgravée sous les espaceurs et la graver de façon anisotrope pour la laisser en place dans cette zone surgravée ; et déposer une quatrième couche de silicium polycristallin dopé de type N et faire diffuser le dopant contenu dans les troisième et quatrième couche pour former l'émetteur du transistor bipolaire.

Selon un mode de réalisation de la présente invention, la première couche de nitrure de silicium a une épaisseur de l'ordre de 50 nm.

Selon un mode de réalisation de la présente invention, les espaceurs ont une largeur à la base de l'ordre de 200 nm et la surgravure de la couche de nitrure de silicium est réalisée sur une largeur de l'ordre de 100 nm.

Selon un mode de réalisation de la présente invention, la troisième couche de silicium polycristallin est dopée à environ 10²⁰ at./cm³ et est de 10 à 100 fois plus dopée que la quatrième couche de silicium polycristallin.

Selon un mode de réalisation de la présente invention, ce procédé comprend l'étape consistant à déposer une deuxième couche de nitrure de silicium entre la première couche de silicium polycristallin ou amorphe dopée de type P et la deuxième couche d'oxyde d'encapsulation.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 11 sont des vues en coupe schématique illustrant des étapes successives de fabrication d'un mode de réalisation d'un transistor MOS à canal N, d'un transistor MOS à canal P et d'un transistor bipolaire de type NPN ;
la figure 12 est une vue agrandie d'un transistor bipolaire de type NPN obtenu par le procédé illustré en figures 1 à 11 ; et
les figures 13 à 17 représentent des étapes de fabrication d'une variante de transistor bipolaire de type NPN selon la présente invention.

Comme cela est usuel dans le domaine de la représentation des composants semiconducteurs, les diverses vues en coupe ne sont pas tracées à l'échelle. Les dimensions latérales et transversales des diverses couches et régions sont arbitrairement dilatées ou rétrécies pour faciliter le tracé des figures.

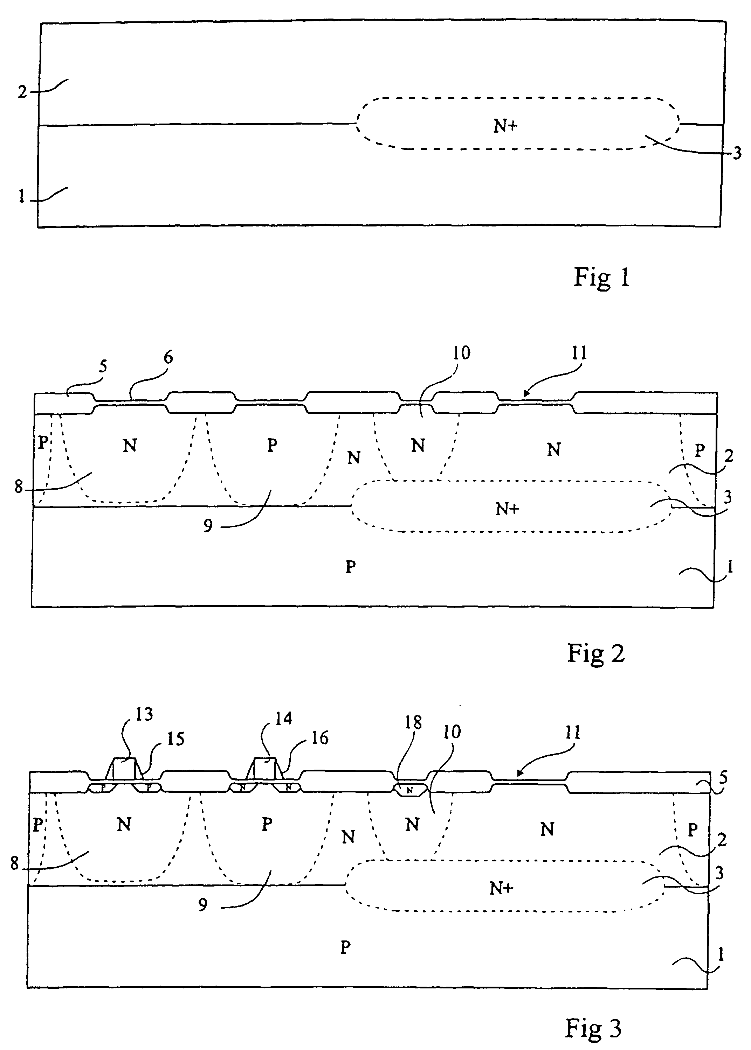

De façon générale dans la suite de la description, on désignera le côté gauche des figures 1 à 11 dans lequel est formé un composant CMOS par l'appellation côté CMOS et le côté droit de ces figures dans lequel est formé un transistor bipolaire de type NPN par l'appellation côté bipolaire. Dans ce qui suit, on décrit la fabrication d'un transistor MOS à canal N, d'un transistor MOS à canal P et d'un transistor bipolaire de type NPN. Bien entendu, dans une réalisation pratique, on formera simultanément de nombreux composants identiques, ainsi qu'éventuellement d'autres types de composants élémentaires.

Selon un aspect de la présente invention, les étapes initiales correspondent à des étapes connues de fabrication de circuits intégrés CMOS de très petites dimensions (dimension minimum, ou dimension de grille, inférieure à 0,35 µm).

Comme le représente la figure 1, on part d'un substrat 1 de type P sur lequel est formée une couche épitaxiale 2 de type N. Cette couche épitaxiale est relativement mince, par exemple d'une épaisseur de l'ordre de 1 à 1,2 µm.

Avant la croissance de la couche épitaxiale, on prévoit si on le souhaite des couches enterrées de types appropriés dans les zones où doivent être formés des caissons N ou P de transistors CMOS et l'on forme une couche enterrée 3 de type N⁺ du côté bipolaire.

Comme le représente la figure 2, du côté MOS, on délimite les régions des transistors MOS par des ouvertures dans une couche d'oxyde épais 5 formée par toute technique connue. On implante, à travers l'oxyde épais ou une région d'oxyde mince 6 formée dans les ouvertures, des caissons 8 de type N et des caissons 9 de type P, de façon classique. Ces caissons sont par exemple formés par une succession de trois implantations dont l'une traverse l'oxyde épais 5 dans des régions non-masquées. Ces caissons N et P sont destinés respectivement à des transistors MOS à canal P et à des transistors MOS à canal N. Le niveau de dopage en surface (quelques 10¹⁶ at./cm³) détermine la tension de seuil des transistors. Dans le cas général, les caissons P (associés à une couche enterrée P⁺) sont en contact électrique avec le substrat P. On pourra toutefois prévoir de former certains au moins des caissons P sur une couche enterrée de type N. Les caissons N sont complètement isolés puisqu'ils débouchent dans le substrat P et ils sont isolés latéralement par des régions P formées comme les caissons P.

Simultanément, côté bipolaire, on délimite dans l'oxyde épais 5 une région dans laquelle sera formée une diffusion profonde de reprise de contact de collecteur ou puits collecteur 10 rejoignant la couche enterrée 3. Ce puits collecteur est formé par au moins certaines des implantations réalisées pour former le caisson 8 de type N, ou bien par une implantation spécifique de type N⁺. Ce puits collecteur peut aussi être formé ultérieurement en même temps que les sources et drains des transistors MOS à canal N. Egalement, on délimite dans l'oxyde épais une zone 11 dans laquelle seront formés la base et l'émetteur d'un transistor bipolaire de type NPN. Pendant les diverses implantations de caissons N et P, cette zone 11 est masquée.

Comme le représente la figure 3, du côté MOS, on forme de façon classique des grilles isolées 13 et 14 des transistors MOS ; on réalise des premières implantations (LDD) ; on forme des espaceurs 15 et 16 ; et on réalise des implantations de drains et de sources. Dans le caisson 8, les implantations sont de type P et, dans le caisson 9, les implantations sont de type N. En même temps que l'on fait les implantations de sources et de drains des transistors à canal N dans les caissons P, on réalise une diffusion de type N fortement dopée 18 à la surface du puits collecteur 10 pour améliorer la prise de contact ultérieure.

On effectue ensuite un recuit thermique rapide (1025°C).

Après cette étape, à la fin de laquelle l'essentiel des transistors MOS a été réalisé (sauf les éventuelles siliciurations de prise de contact et les métallisations), on procède à la réalisation du transistor bipolaire de type NPN.

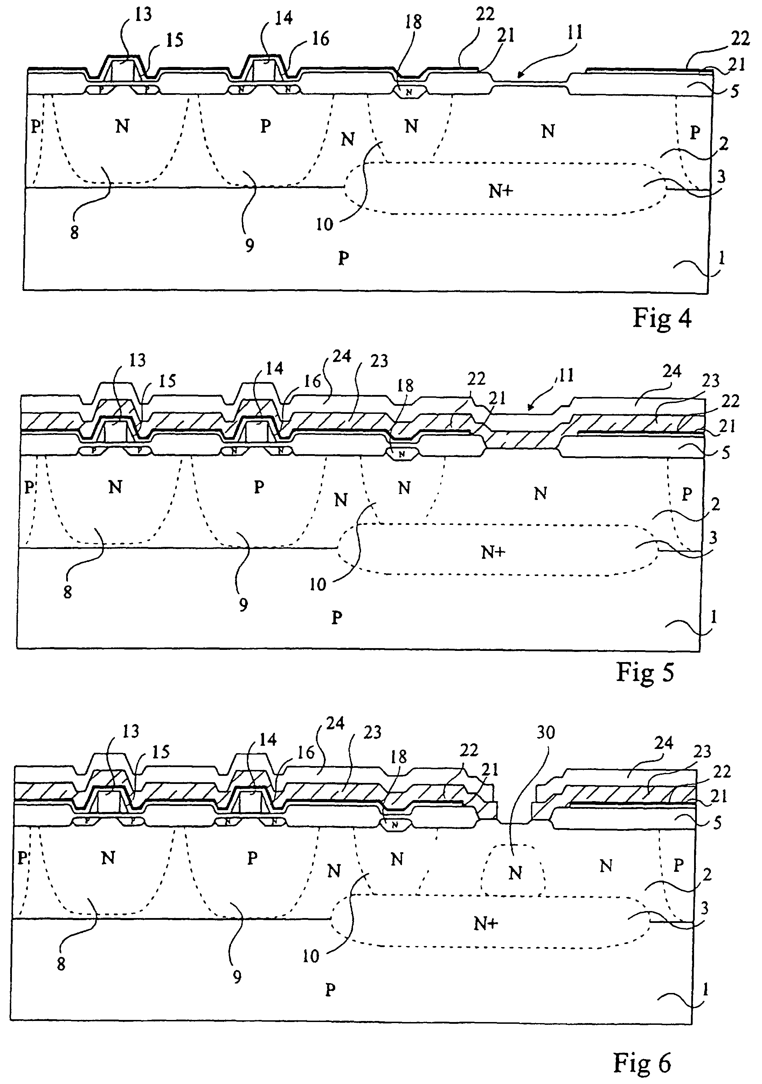

A l'étape illustrée en figure 4, on dépose sur l'ensemble de la structure, par voie chimique en phase vapeur, une double couche de protection comprenant une couche d'oxyde de silicium 21 ayant par exemple une épaisseur de l'ordre de 20 nm suivie d'une couche de nitrure de silicium 22 ayant par exemple une épaisseur de l'ordre de 30 nm. Cette couche 21-22 est ouverte dans la zone 11 où l'on souhaite former la région émetteur-base d'un transistor bipolaire. On notera que cette ouverture n'est pas critique puisqu'elle s'arrête sur des régions d'oxyde épais.

A l'étape illustrée en figure 5, on dépose sur l'ensemble de la structure une couche de silicium 23 ayant par exemple une épaisseur de l'ordre de 200 nm suivie d'une couche d'oxyde d'encapsulation 24 ayant par exemple une épaisseur de l'ordre de 300 nm.

La couche de silicium 23 doit être dopée de type P puisqu'elle servira comme on le verra ci-après de source de dopage pour la base extrinsèque du transistor NPN et sera appelée silicium polycristallin de base. Bien qu'elle soit désignée sous l'appellation silicium polycristallin, il pourra aussi s'agir de tout type de couche de silicium déposé, par exemple du silicium amorphe. De préférence, selon un aspect de la présente invention, on procède d'abord au dépôt d'une couche 23 de silicium polycristallin ou amorphe non dopé et l'on procède ensuite à une implantation d'un dopant de type P dans cette couche. De préférence, on implante du bore sous forme de BF₂ à très forte dose (10¹⁵ à 10¹⁶ at./cm²) et à faible énergie de sorte que le bore implanté se concentre dans la partie supérieure de la couche en évitant toute implantation de bore dans le substrat de silicium sous-jacent dans la région 11.

A l'étape illustrée en figure 6, on procède à une ouverture des couches 24 et 23 dans la partie centrale de la région 11. Cette ouverture a par exemple une largeur comprise entre 0,4 et 0,8 µm et pénètre dans le silicium monocristallin de moins de 50 nm. On procède ensuite à une implantation d'un dopant de type N pour définir le collecteur 30 du transistor NPN. Ce collecteur est donc auto-aligné sur l'ouverture. L'implantation N est réalisée à dose moyenne et forte énergie (par exemple, 10¹² à 10¹⁴ at./cm² sous 500 keV). On obtient ainsi une région effective de collecteur d'étendue latérale limitée, sensiblement égale à celle de la base intrinsèque qui est formée ensuite. Ceci contribue à l'obtention d'un transistor NPN de faible capacité parasite entre collecteur et base extrinsèque. L'implantation est optimisée (par exemple, par implantations successives) pour que le profil du collecteur fournisse le meilleur compromis possible entre, d'une part, la résistance de collecteur et le temps de transit dans ce collecteur et, d'autre part, l'obtention de tensions de claquage suffisamment élevées émetteur-collecteur (typiquement 4 volts) et base-collecteur et d'une faible capacité base-collecteur. On notera aussi que cette implantation de collecteur permet de choisir au préalable une couche épitaxiée 2 de dopage et d'épaisseur propres à optimiser les transistors CMOS et d'optimiser ensuite indépendamment les caractéristiques des transistors NPN. Notamment, cette couche épitaxiée pourra être plus épaisse que si elle devait servir directement de couche de collecteur du transistor NPN.

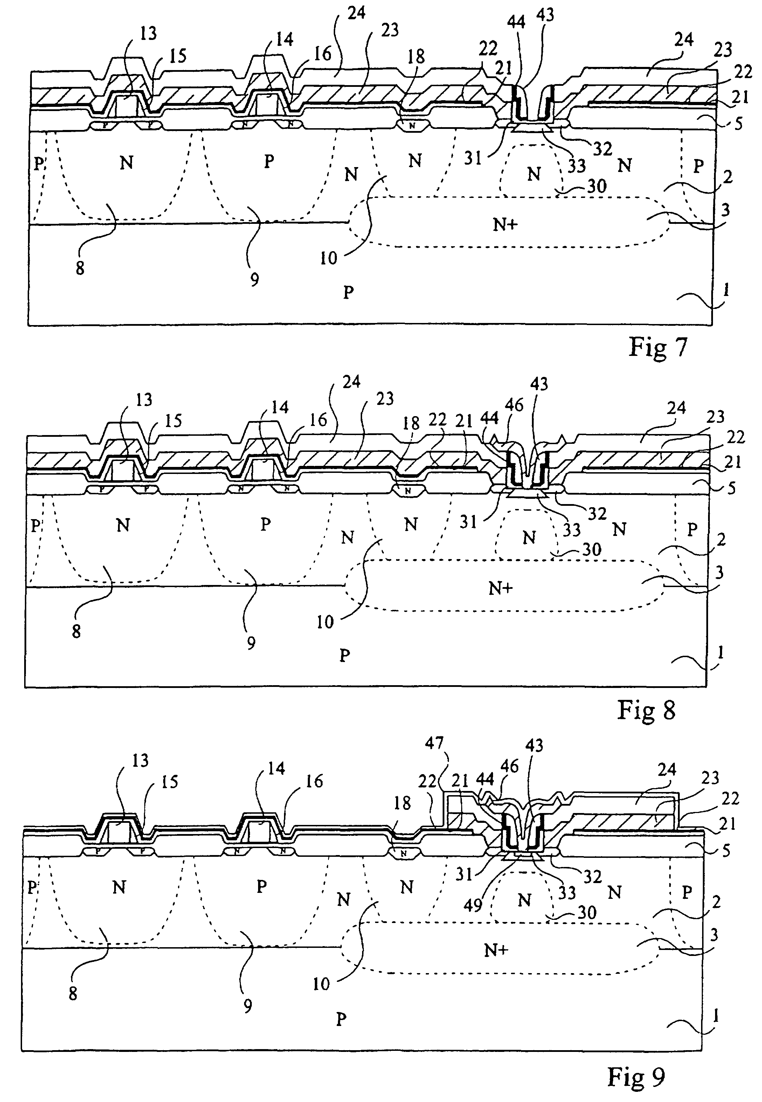

Comme le représente la figure 7, après élimination de la résine de masquage, on procède à une oxydation thermique pendant laquelle il se forme une mince couche d'oxyde thermique 31 d'une épaisseur de l'ordre de 5 à 10 nm et pendant laquelle le bore contenu dans la couche de silicium polycristallin 23 commence à diffuser dans la couche épitaxiée sous-jacente pour former une région de base extrinsèque 32 ayant par exemple une profondeur de jonction de l'ordre de 100 nm. Cette diffusion est ensuite complétée par le recuit final de la structure bipolaire. On procède alors à une implantation de type P à travers l'oxyde 31 pour former une région de base intrinsèque 33 au centre de l'ouverture dans les couches 23 et 24. Cette base intrinsèque est de préférence implantée au bore à faible énergie (par exemple, 10¹³ at./cm² sous 5 keV). Le contact avec le silicium polycristallin 23 résulte de la diffusion latérale du bore du silicium polycristallin.

On procède alors à un dépôt uniforme d'une couche mince de nitrure de silicium (30 nm) revêtue d'une couche de silicium polycristallin (100 nm). La couche de silicium polycristallin est ensuite gravée de façon anisotrope de façon qu'il n'en demeure que des espaceurs 43 sur les flancs de l'ouverture ménagée dans les couches 23 et 24. On procède ensuite à une gravure uniforme du nitrure de silicium, de sorte que ce nitrure de silicium reste en place seulement dans les régions 44 où il est protégé de la gravure (chimique ou plasma) par les espaceurs 43 de silicium polycristallin. L'ensemble du nitrure 44 et des espaceurs 43 définit donc une ouverture plus petite que l'ouverture initialement formée dans les couches 23 et 24 pour la définition de la base intrinsèque. Cette ouverture plus petite est l'ouverture d'émetteur. Si les espaceurs ont une largeur de l'ordre de 150 nm chacun, cette petite ouverture a une largeur de l'ordre de 0,5 µm.

A l'étape illustrée en figure 8, la couche mince d'oxyde 31 au fond de l'ouverture, qui avait servi de protection pendant l'implantation d'émetteur (bore) et d'arrêt de gravure de la couche de nitrure de silicium, est soigneusement nettoyée, par exemple dans un bain d'acide fluorhydrique dilué. On dépose une couche de silicium polycristallin fortement dopé de type N qui est ensuite gravée pour laisser en place une région 46. Des régions de la couche de silicium polycristallin dopé 46 peuvent être maintenues en place en des endroits choisis pour former par exemple des condensateurs entre des régions de ce silicium polycristallin 46 et des régions du silicium polycristallin de base 23.

A l'étape illustrée en figure 9, on élimine les couches d'oxyde 24 et de silicium polycristallin de base 23 en dehors de la région d'émetteur-base du transistor bipolaire et d'autres régions éventuelles comportant des dispositifs utilisant des portions de la couche de silicium polycristallin de base 23 (résistances, capacités...). Puis l'on dépose une couche d'oxyde de silicium d'encapsulation 47.

Après cela, on procède à un recuit de pénétration du dopant contenu dans la couche de silicium polycristallin 46 au centre de la région de base du transistor pour former son émetteur 49 de type N. Les recuits associés au transistor bipolaire assurent une réactivation électrique des dopants et conduisent à des profondeurs de jonction de l'ordre de 60 nm. Les recuits sont du type recuit thermique rapide et/ou au four. Le traitement thermique (30 s, 1000°C) est plus léger que pour les transistors MOS qui ne sont donc pas affectés.

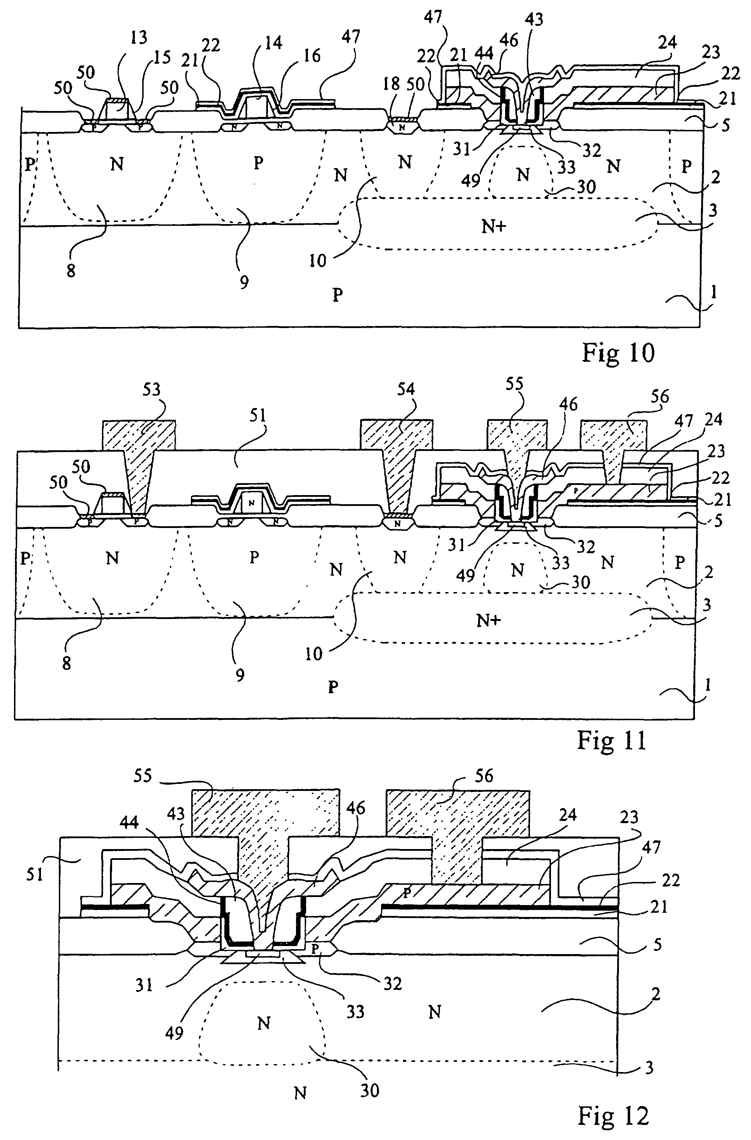

A l'étape illustrée en figure 10, on élimine les couches d'oxyde de silicium d'encapsulation 47, de nitrure de silicium 22 et d'oxyde de silicium de protection 21 au-dessus des zones actives et/ou de silicium polycristallin que l'on souhaite siliciurer, par exemple le transistor MOS à canal P et le puits collecteur du transistor bipolaire. Un siliciure métallique 50 est formé sélectivement au-dessus des régions exposées de silicium mono et polycristallin.

A l'étape illustrée en figure 11, on procède au dépôt d'une couche isolante de planarisation 51 par tout procédé connu, par exemple par dépôt d'une couche de verre dopé au bore et au phosphore (BPSG) et recuit, puis on ouvre cette couche et d'éventuelles couches sous-jacentes aux emplacements où l'on veut prendre des contacts. Seuls certains contacts ont été représentés car, comme cela est bien connu, les contacts ne sont pas nécessairement pris directement au-dessus des zones utiles mais éventuellement sur des prolongements transverses de régions conductrices s'étendant à partir de ces zones utiles. Ainsi, en figure 11, on a seulement représenté un contact de drain 53 d'un transistor MOS à canal P, un contact de collecteur 54, un contact d'émetteur 55 et un contact de base 56 du transistor bipolaire.

La figure 12 correspond au côté bipolaire de la figure 11 et représente la région d'émetteur-base du transistor bipolaire à plus grande échelle.

Dans un mode de réalisation particulier, et pour donner un exemple d'ordres de grandeur, on pourra choisir de réaliser une structure avec les données numériques suivantes (où e désigne une épaisseur, et Cs une concentration superficielle ou une concentration moyenne pour une couche homogène) :

| | |
|---|---|
| substrat 1 | Cs = 10¹⁵ at./cm³, |
| couche épi 2 | Cs = 10¹⁶ at./cm³, e = 0,8 à 1,4 µm, |
| couche enterrée 3 | Cs = 10²⁰ at./cm³, |
| oxyde 5 | e = 0,5 µm, |
| sources et drains N ou P | Cs = 10²⁰ at./cm³, e = 0,15 µm. |

Le procédé de fabrication décrit ci-dessus, tout en étant parfaitement compatible avec les filières existantes de fabrication de transistors CMOS à haute définition, permet de réaliser un transistor bipolaire dont les régions de collecteur, de base intrinsèque et d'émetteur sont auto-alignées.

Ce transistor bipolaire présente de nombreux avantages. Ses performances ne souffrent pas de la présence des transistors CMOS. Il peut en particulier être utilisé aux radiofréquences (fréquence de coupure supérieure à 40 GHz). La très forte transconductance et le faible bruit du transistor bipolaire le rendent apte à des applications analogiques. En particulier, le contact de base (en silicium polycristallin P⁺) permet une forte réduction de la résistance de base d'où un facteur de bruit RF intéressant. Ainsi, le transistor bipolaire peut être utilisé en lieu et place de certains transistors AsGa avec un coût moindre et la possibilité de l'associer sur une même puce à un circuit CMOS très performant.

La présente invention vise une variante du procédé décrit ci-dessus destinée à améliorer encore les performances du transistor bipolaire.

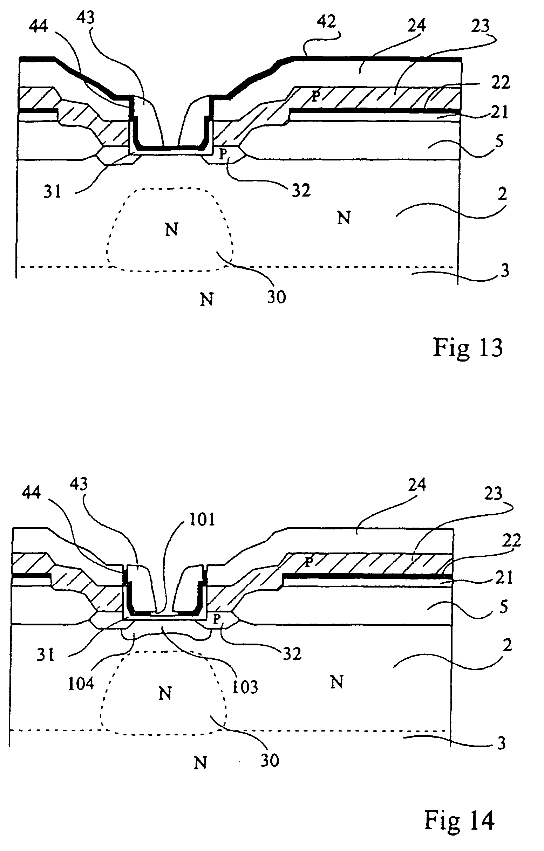

La figure 13 représente la structure de transistor bipolaire décrite précédemment à une étape intermédiaire entre celles illustrées en figures 6 et 7, à savoir que les espaceurs 43 ont été formés mais que la couche de nitrure de silicium 42 dont une portion 44 est enfermée par les espaceurs 43 n'a pas encore été gravée.

On aura choisi une structure dans laquelle les espaceurs en silicium polycristallin 43 ont une largeur (une étendue latérale) au pied de l'ouverture de l'ordre de 200 nm et l'épaisseur de la couche de nitrure de silicium 42 est de l'ordre de 50 nm, c'est-à-dire plus épaisse que ce qui a été décrit dans le mode de réalisation précédent.

A l'étape suivante, illustrée en figure 14, comme précédemment, on grave la couche de nitrure de silicium 42. Toutefois, cette gravure est maintenant nécessairement effectuée de façon isotrope (par exemple, une gravure chimique par H₃PO₄) et est poursuivie pour que le nitrure de silicium soit gravé en retrait sous les pieds des espaceurs. On forme ainsi une zone creuse 101 ayant par exemple une étendue de 100 nm en bas de la périphérie interne de l'ouverture.

Toujours à l'étape illustrée en figure 14, on procède à une implantation de base. Cette implantation est de préférence réalisée en deux étapes. D'une part, une implantation verticale, d'autre part, une implantation sous incidence oblique à un angle maximum compatible avec la forme des espaceurs. On obtient ainsi une région de base comportant une partie centrale 103 moins profonde et une partie latérale 104 s'étendant de façon à rejoindre la région de contact de base 32.

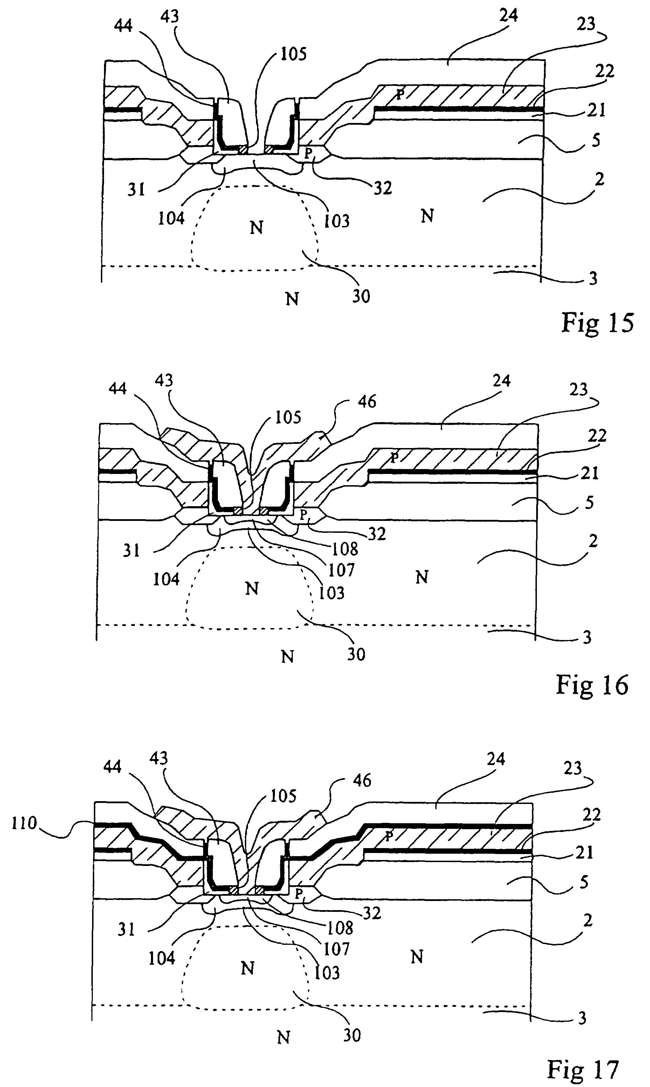

A l'étape illustrée en figure 15, on grave la couche d'oxyde thermique mince 31 là où elle a été découverte par enlèvement de la couche de nitrure puis on dépose une couche de silicium polycristallin fortement dopé in situ de type N, par exemple quelques 10²⁰ atomes/cm³, ayant par exemple une épaisseur de 25 nm, puis l'on procède à une gravure anisotrope verticale de cette couche. Il reste ainsi en place dans les évidements 101 des portions 105 de cette couche de silicium polycristallin dopé de type N. Une partie de cette couche de silicium polycristallin (non représentée) demeure également en place sur le flanc des espaceurs et contribuera à réduire la résistance d'accès à l'émetteur.

Une fois cette étape réalisée, on reprend les étapes décrites précédemment et illustrées à partir de la figure 8. Comme le représente la figure 16, on dépose et on grave la couche de silicium polycristallin 46 décrite précédemment. Dans la présente variante, cette couche de silicium polycristallin 46 est moins dopée que le silicium polycristallin 105, par exemple 10 à 100 fois moins dopée.

Ainsi, après diffusion, on obtient une zone d'émetteur ayant l'allure représentée, c'est-à-dire une partie centrale plus faiblement dopée 108 en contact avec le silicium polycristallin de prise de contact d'émetteur 46 et une zone plus fortement dopée 108 sous les régions 105.

Après cela, les étapes de fabrication se poursuivent comme cela a été décrit précédemment.

Une telle structure d'émetteur à dopage inhomogène présente plusieurs avantages. Notamment, le fait que le dopage de la zone de silicium polycristallin assurant la conduction vers le contact soit le plus faible possible permet d'éviter de recombiner les trous minoritaires venant de la base. Par contre, en raison du plus fort niveau de dopage de la périphérie de l'émetteur, l'efficacité d'injection est augmentée. Ainsi, une structure de ce type permet d'augmenter le courant injecté et de diminuer le courant parasite de base, tout en conservant les avantages inhérents à la structure décrite précédemment en relation avec les figures 1 à 12.

Un inconvénient éventuel de la structure illustrée en figure 16 est que, en même temps que l'on a gravé latéralement la couche de nitrure de silicium 42 dans la zone inférieure, cette couche a été gravée verticalement à l'interface entre l'espaceur 43 et la couche d'oxyde de silicium 24. Les deux couches de silicium polycristallin 23 et 46 se trouve alors proches l'une de l'autre dans cette zone qui peut être perturbée par diverses opérations de gravure et il existe un risque de court-circuit entre le silicium polycristallin de base et le silicium d'émetteur.

Pour éviter cet inconvénient, on pourra recourir à la variante illustrée en figure 17. Cette figure est identique à la figure 16 sauf qu'une couche de nitrure de silicium 110 a été formée à l'interface des couches d'oxyde de silicium 24 et de silicium polycristallin 23. Ceci présente l'avantage que lors du dépôt de la couche de nitrure de silicium 42, cette couche de nitrure de silicium 42 aura tendance à se souder avec le bord adjacent de la couche de nitrure de silicium 110. On diminue ainsi fortement le risque de possibilité de court-circuit entre les couches de silicium polycristallin 23 et 46.

L'homme de l'art notera que d'autres composants peuvent être imaginés en utilisant la filière selon la présente invention et que celle-ci est susceptible de diverses variantes et modifications. Notamment, les diverses valeurs numériques indiquées l'ont été uniquement à titre d'exemple et chaque matériau indiqué à titre d'exemple pourra être remplacé par un autre matériau ayant la même fonction (par exemple sélectivité de gravure par rapport à d'autres matériaux). De plus, divers composants élémentaires pourront être réalisés avec ou sans couche enterrée de l'un ou l'autre type de conductivité.

## Revendications

1. Procédé de fabrication d'un circuit intégré comprenant un transistor bipolaire de type NPN comprenant les étapes suivantes consécutives :
former une couche épitaxiée (2) de type N sur un substrat (1) de type P, une couche enterrée (3) étant prévue au moins à l'emplacement du transistor bipolaire ;
former une couche d'oxyde épais ouverte à l'emplacement de base-émetteur du transistor bipolaire ;
former une première couche de silicium polycristallin ou amorphe (23) dopée de type P et une deuxième couche d'oxyde d'encapsulation (24) ;
ouvrir ces deux dernières couches (23, 24) au centre de la région d'émetteur-base du transistor bipolaire ;
faire diffuser le dopant contenu dans la première couche de silicium polycristallin ou amorphe (23) dans la couche épitaxiée sous-jacente, pour former la base extrinsèque du transistor bipolaire, étape pendant laquelle il se forme une couche mince d'oxyde (31) sur les surfaces apparentes de silicium ;
déposer une première couche de nitrure de silicium (42), déposer une deuxième couche de silicium polycristallin (43), et graver de façon anisotrope la deuxième couche de silicium polycristallin pour laisser en place des espaceurs dans les portions verticales de celle-ci ;
éliminer le nitrure de silicium apparent et le surgraver sous les espaceurs ;
éliminer la couche mince d'oxyde (31) aux emplacements où le nitrure de silicium apparent a été surgravé
implanter un dopant de collecteur de type N (30) ;
implanter un dopant de type P (33) pour former la base intrinsèque du transistor bipolaire ;
déposer une troisième couche de silicium polycristallin (105) fortement dopé de type N de façon qu'elle pénètre dans la zone surgravée sous les espaceurs et la graver de façon anisotrope pour la laisser en place dans cette zone surgravée et
déposer une quatrième couche de silicium polycristallin (46) dopé de type N et faire diffuser le dopant contenu dans les troisième et quatrième couches pour former l'émetteur (107, 108) du transistor bipolaire.

2. Procédé selon la revendication 1, **caractérisé en ce que** la première couche de nitrure de silicium (42) a une épaisseur de l'ordre de 50 nm.

3. Procédé selon la revendication 1, **caractérisé en ce que** les espaceurs ont une largeur à la base de l'ordre de 200 nm et **en ce que** la surgravure de la couche de nitrure de silicium est réalisée sur une largeur de l'ordre de 100 nm.

4. Procédé selon la revendication 1, **caractérisé en ce que** la troisième couche de silicium polycristallin (105) est dopée à environ 10²⁰ at./cm³ et est de 10 à 100 fois plus dopée que la quatrième couche de silicium polycristallin (46).

5. Procédé selon la revendication 1, **caractérisé en ce qu'**il comprend l'étape consistant à déposer une deuxième couche de nitrure de silicium (110) entre la première couche de silicium polycristallin ou amorphe (23) dopée de type P et la deuxième couche d'oxyde d'encapsulation (24).

## Patentansprüche

1. Verfahren zum Herstellen eines integrierten Schaltkreises mit einem bipolaren NPN-Transistor, das die folgenden aufeinanderfolgenden Schritte umfaßt:
Ausbilden einer N-Epitaxieschicht (2) auf einem P-Substrat (1), wobei eine vergrabenen Schicht (3) zumindest an der Stelle des bipolaren Transistors vorgesehen ist; Ausbilden einer dicken Oxidschicht, die an der Basis-Emitterstelle des bipolaren Transistors offen ist;
Ausbilden einer ersten P-dotierten, polykristallinen oder amorphen Siliziumschicht (23) und einer zweiten Verkapselungs-Oxidschicht (24);
Öffnen dieser letzten zwei Schichten (23, 24) an der Mitte des Basis-Emitterbereichs des bipolaren Transistors;
Diffundierenlassen des in der ersten polykristallinen oder amorphen Siliziumschicht (23) enthaltenen Dotierstoffmittels in die darunter liegende Epitaxieschicht, um die extrinsische Basis des bipolaren Transistors zu bilden, wobei in diesem Schritt eine dünne Oxidschicht (31) auf den sichtbaren Oberflächen des Siliziums ausgebildet wird; Abscheiden einer ersten Siliziumnitridschicht (42), Abscheiden einer zweiten polykristallinen Siliziumschicht (43) und anisotropes Ätzen der zweiten polykristallinen Siliziumschicht, um an deren vertikalen Abschnitten Abstandhalter zurückzulassen;
Entfernen und Überätzen des sichtbaren Siliziumnitrids unterhalb der Abstandhalter; Entfernen der dünnen Oxidschicht (31) an Stellen, an denen das sichtbare Siliziumnitrid überätzt wurde;
Implantieren eines Kollektor-Dotierstoffs (30) des N-Typs;
Implantieren eines P-Dotierstoffs (33), um die intrinsische Basis des bipolaren Transistors auszubilden;
Abscheiden einer dritten stark N-dotierten polykristallinen Siliziumschicht (105), so daß diese in die überätzten Zonen unterhalb der Abstandhalter eindringt, und anisotropes Ätzen dieser Schicht, um diese in der überätzten Zone zurückzulassen; und
Abscheiden einer vierten N-dotierten polykristallinen Siliziumschicht (46) und Diffundierenlassen des in der dritten und vierten Schicht enthaltenen Dotierstoffs, um den Emitter (107, 108) des bipolaren Transistors auszubilden.

2. Verfahren nach Anspruch 1, **dadurch gekennzeichnet daß** die zweite Siliziumnitridschicht (42) eine Dicke in der Größenordnung von 50 nm aufweist.

3. Verfahren nach Anspruch 1, **dadurch gekennzeichnet, daß** die Abstandhalter an der Basis eine Länge in der Größenordnung von 200 nm aufweisen, und daß die Überätzung der Siliziumnitridschicht über eine Länge in der Größenordnung von 100 nm durchgeführt wird.

4. Verfahren nach Anspruch 1, **dadurch gekennzeichnet, daß** die dritte polykristalline Siliziumschicht (105) mit etwa 10²⁰ Atome/cm³ dotiert wird und daß sie 10 bis 100 mal stärker dotiert wird, als die vierte polykristalline Siliziumschicht (46).

5. Verfahren nach Anspruch 1, **dadurch gekennzeichnet, daß** es den Schritt des Abscheidens einer zweiten Siliziumnitridschicht (110) zwischen der ersten P-dotierten polykristallinen oder amorphen Siliziumschicht (23) und der zweiten Verkapselungs-Oxidschicht (24) umfaßt.

## Claims

1. A method for fabricating an integrated circuit including a bipolar transistor of NPN type, including the following consecutive steps:
forming an N-type epitaxial layer (2) on a P-type substrate (1), a buried layer (3) being provided at least at the location of the bipolar transistor;
forming a thick oxide layer open at the base-emitter location of the bipolar transistor;
forming a first P-type doped polysilicon or amorphous silicon layer (23) and a second encapsulation oxide layer (24);
opening these last two layers (23, 24) at the center of the base-emitter region of the bipolar transistor;
diffusing the doping contained in the first polysilicon or amorphous silicon layer (23) in the underlying epitaxial layer, to form the extrinsic base of the bipolar transistor, during which step a thin oxide layer (31) forms on the apparent silicon surfaces;
depositing a first layer of silicon nitride (42), depositing a second layer of polysilicon (43), and anisotropically etching the second polysilicon layer to leave in place spacers in the vertical portions thereof;
removing the apparent silicon nitride and overetching it under the spacers;
removing the thin oxide layer (31) at the locations where the apparent silicon nitride has been overetched;
implanting an N-type collector doping (30);
implanting a P-type doping (33) to form the intrinsic base of the bipolar transistor;
depositing a third highly-doped N-type polysilicon layer (105) so that it penetrates into the overetched area under the spacers and etching it anisotropically to leave it in place in this overetched area; and
depositing a fourth N-type doped polysilicon layer (46) and diffusing the doping contained in the third and fourth layers to form the emitter (107, 108) of the bipolar transistor.

2. A method according to claim 1, **characterized in that** the first silicon nitride layer (42) has a thickness of around 50 nm.

3. A method according to claim 1, **characterized in that** the spacers have a base length of around 200 nm and the overetching of the silicon nitride layer is performed across a width of around 100 nm.

4. A method according to claim 1, **characterized in that** the third polysilicon layer (105) is doped to about 10²⁰ at./cm³ and is from 10 to 100 times as doped as the fourth polysilicon layer (46).

5. A method according to claim 1, **characterized in that** it includes the step of depositing a second silicon nitride layer (110) between the first P-type doped polysilicon or amorphous silicon layer (23) and the second encapsulation oxide layer (24).
